# EUROPEAN PATENT SPECIFICATION

(11) **EP 2 784 519 B1**
(45) Date of publication and mention of the grant of the patent: **09.11.2016**
(21) Application number: 12842563.4
(22) Date of filing: 25.06.2012
(51) Int. Cl.: G01R 1/067, G01R 31/26, G01R 3/00

(54) **METHOD FOR MANUFACTURING A CONTACT FOR TESTING A SEMICONDUCTOR DEVICE**
VERFAHREN ZUR HERSTELLUNG EINES KONTAKTS ZUM TESTEN EINER HALBLEITERVORRICHTUNG
PROCÉDÉ DE FABRICATION D'UN CONTACT DESTINÉ À TESTER UN DISPOSITIF À SEMI-CONDUCTEURS

(30) Priority: 19.10.2011 KR 20110106832
(43) Date of publication of application: 01.10.2014
(73) Proprietor: Siliconevalley Co., Ltd, Gim Cheon-si, Gyeongsangbuk-do 740-180 (KR)
(72) Inventor: YOUN, Kyoungseob, Kyungsangbuk-do 730-921 (KR)
(74) Representative: Grünecker Patent- und Rechtsanwälte PartG mbB
(86) International application number: PCT/KR2012/004979
(87) International publication number: WO 2013/058465

(56) References cited:
- JP-A- H0 645 025
- JP-A- H06 331 654
- JP-A- 2002 031 646
- JP-A- 2002 031 646
- KR-B1- 100 796 172
- US-B1- 6 617 863

## Description

### [Technical Field]

The present invention relates to a contact for a test socket in which conductor portions are formed so as to be arranged at certain intervals on a dielectric plate used for testing whether a semiconductor device is normal by contacting a read terminal of the semiconductor device, and more particularly, to a method for manufacturing a contact for testing a semiconductor device, wherein a dielectric plate and a conductor portion are continuously alternately bonded and stacked repeatedly, one side of the stack is cut, then the stack and a dielectric layer are again subjected to repeated alternating bonding and stacking, after which the front surface of the stack is cut to yield a new type of contact. Thus, the pitch between adjacent conductor portions can be determined according to the thickness at which layers are formed and the cut width in the manufacturing process, so that a desired pitch of the conductor portion can be achieved.

### [Background Art]

Generally, when a semiconductor device has been manufactured, the semiconductor device is tested via an electrical test on whether or not the operation thereof is normal. Here, a contact is used as a test socket for the semiconductor testing equipment.

Generally, the contact is in the form of a plate in which a plurality of circular conductor portions are arranged at regular intervals on a dielectric plate. A semiconductor device is tested using the contact in such a way that a lead terminal of the semiconductor device is brought into contact with the conductor portion on the contact, and a socket board is disposed on a lower portion of the contact so as to generally supply electricity to the conductor portion, followed by analyzing input and output signals for the semiconductor device.

Here, the pitch of the conductor portion formed on the contact is very important, because as manufacturing techniques are being developed, semiconductor devices are made smaller, leading to an interval between lead terminals of just a few microns, so if the pitch is large there are many restrictions on contact, a position, a quantity, a disposition, etc.

A most commonly used method of manufacturing such a contact is such that a perforated dielectric plate is filled with a conductor material. In this method, however, the size of the perforation and the pitch between perforations cannot be physically made narrower than 250 µm, hundreds of thousands of perforations are required, so the time taken for forming the perforations is prolonged, and, during the perforating process or due to hundreds of thousands of perforations themselves, the dielectric plate becomes structurally weak, thereby being subjected to breakage, cracks, deformation, etc.

Thus, a contact manufactured using such a manufacturing method, or a die for manufacturing the contact has limits to properly form the size of the perforation or pitch of the perforations for forming a conductor portion, as well as it is difficult to manufacture the contact or the die. Further, a high-tech micro milling machine is required in order to increase precision, so a manufacturing cost increases. Furthermore, upon machining with the precision of 250 µm or less, even such a micro milling machine also has a high error rate due to a mechanical error during micro machining.

In the meantime, another method of manufacturing a contact has been proposed in Korean Patent No. 10-0448414, in which conductive metal powders are provided in a liquefied dielectric, a magnetic force is applied towards the dielectric from both upper and lower portions so that metal powders can be magnetically collected and formed into conductive pillars, followed by carrying out a curing process. This method also has problems in that, because upper and lower dies, magnets, a pin for applying magnetic force, and the like essentially require perforations according to the above-mentioned machining method, there are limitations in narrowing a pitch.

Additionally, the Japanese Patent JP H06 45025 A discloses an anisotropic conductive connector by constituting a zebra-like sheet of a conductor layer composed of conductive non-woven fabric and a conductive rubber-like member, and an insulating rubber-like member, and alternately superposing the sheet on an insulating rubber-like member in alignment in the arranging direction of the conductor layer of the sheet.

Further, when the conductive pillars are magnetically formed, the movement of metal powders is not easy due to the viscosity of liquid, so that it is difficult to provide a vertical alignment, and there is a risk of adjacent conductive pillars being interlinked, causing an electrical connection error. This method enables easy manufacture compared to the related art technology, but has a reduced reliability in the manufacture.

### [Disclosure]

### [Technical Problem]

Accordingly, the present invention has been made keeping in mind the above problems occurring in the related art, and is intended to provide a new-type of method of manufacturing a contact without a perforating process, wherein a pitch between adjacent conductor portions is considerably narrowed with repetitive alternating continuous stacking and cutting, and precision and reliability of a test for a semiconductor device are secured with definite separation between conductor portions.

### [Technical Solution]

According to an aspect of the present invention, a method, as defined in claim 1, of manufacturing a contact for testing a semiconductor device is provided.

According to the above method, the contact is formed as the first cut body, which includes a plurality of sets of a dielectric layer and a conductor layer provided on one side of the dielectric layer, wherein the dielectric layer extends in a longitudinal direction thereof, and the conductor layer extends in a longitudinal direction thereof, wherein the sets of the dielectric layer and the conductor layer are repeatedly stacked on one another in one direction.

According to the above method, the contact is formed as the first cut body, which includes a plurality of sets of a dielectric layer and a second layer provided on one side of the dielectric layer, wherein the dielectric layer extends in a longitudinal direction thereof, and the second layer consists of a plurality of pairs of a dielectric part and a conductor part, the pairs being continuously provided in a longitudinal direction of the second layer, wherein the sets of the dielectric layer and the second layer are repeatedly stacked on one another in one direction.

### [Advantageous Effects]

According to the present invention, since the pitch between adjacent conductor portions can be determined according to the thickness at which dielectric layer 2 and the conductor layer 1 are formed and the cut width in the manufacturing process, a very narrow pitch can be achieved as compared to the related art which requires a perforating process.

Further, the layer can be easily formed or cut without using a high-tech method, leading to an easy and precise manufacturing process with low cost while improving precision only using the manufacturing method itself.

Further, since the size, interval or the like of the dielectric layer or part, and the conductor layer or part can freely regulate the thickness at which the layer is formed and the cut width of the layer, the layers can be formed in a diversity of forms while the pitch is made narrow.

Such a narrow pitch between conductor parts or layers can be easily adaptable to a test for a micro semiconductor device of which the width of a lead is very narrow, and it enables free and easy arrangement of the semiconductor device on the contact with respect to a position, an interval, a quantity, displacement, etc. of the semiconductor device.

Further, the dielectric layer and the conductor layer are separately stacked, so that the two layer are not interlinked, thereby providing reliable conductivity and therefore precise test of the semiconductor device.

### [Description of Drawings]

FIG. 1 is a view illustrating the technology according to the related art.
FIG. 2 is a view illustrating the technology according to the present invention.
FIG. 3 is another view illustrating the technology according to the present invention.
FIG. 4 is a view illustrating a fabricating method according to the present invention.
FIG. 5 is a view illustrating an exemplary implementation of the present invention.

### [Best Mode]

According to an aspect of the present invention, a method of manufacturing a contact for testing a semiconductor device is provided. The method includes a first stacking stage of continuously alternately bonding and stacking a dielectric layer and a conductor layer on one another to a certain height, forming a first stacked body; a first cutting stage of vertically cutting a lateral side of the first stacked body by a constant thickness across a whole height of the first stacked body, forming a first cut body which consists of a plurality of sets of a dielectric layer and a conductor layer, which extends in longitudinal directions, respectively, wherein the sets being continuously arranged on one another; a second stacking stage of continuously alternately bonding and stacking the first cut body being disposed flat and another dielectric layer in parallel on one another to a certain height, forming a second stacked body; and a second cutting stage of vertically cutting a lateral side of the second stacked body by a constant thickness across a whole height of the second stacked body, forming a second cut body which consists of a plurality of sets of a dielectric layer and a second layer disposed on one side of the dielectric layer, wherein the dielectric layer extends in a longitudinal direction thereof, and the second layer consists of a plurality of pairs of a dielectric part and a conductor part, the pairs being continuously provided in a longitudinal direction of the second layer, wherein the sets of the dielectric layer and the second layer are repeatedly stacked on one another.

According to the above method, the contact is formed as the first cut body, which includes a plurality of sets of a dielectric layer and a conductor layer provided on one side of the dielectric layer, wherein the dielectric layer extends in a longitudinal direction thereof, and the conductor layer extends in a longitudinal direction thereof, wherein the sets of the dielectric layer and the conductor layer are repeatedly stacked on one another in one direction.

According to the above method, the contact is formed as the first cut body, which includes a plurality of sets of a dielectric layer and a second layer provided on one side of the dielectric layer, wherein the dielectric layer extends in a longitudinal direction thereof, and the second layer consists of a plurality of pairs of a dielectric part and a conductor part, the pairs being continuously provided in a longitudinal direction of the second layer, wherein the sets of the dielectric layer and the second layer are repeatedly stacked on one another in one direction.

### [Mode for Invention]

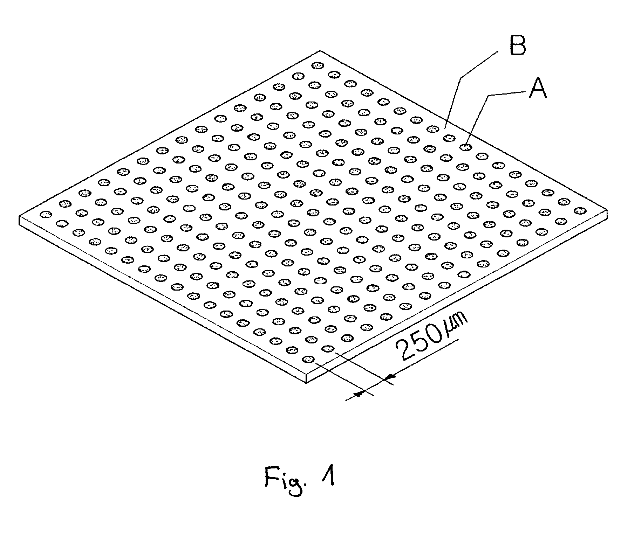

First, referring to a contact shown in FIG. 1 which is manufactured by a conventional method, the contact is configured so that a plurality of electrically conductive column-type portions A are uniformly arranged on an electrically nonconductive dielectric plate B.

As described before, this configuration is obtained by filling a perforated dielectric plate B with a conductive material, or as disclosed in the above-mentioned cited document, by providing conductive metal powders in a liquefied dielectric and magnetically forming conductive pillars.

However, both the methods essentially require perforations, which are formed directly in the dielectric plate or in dies by a mechanical machining method, in order to fabricate a contact. Here, since a pitch of perforations formed by mechanical machining can be physically limited to 250 µm or more, in the case of micro semiconductor device, there are many limitations on contact, a position, a quantity, a disposition, etc.

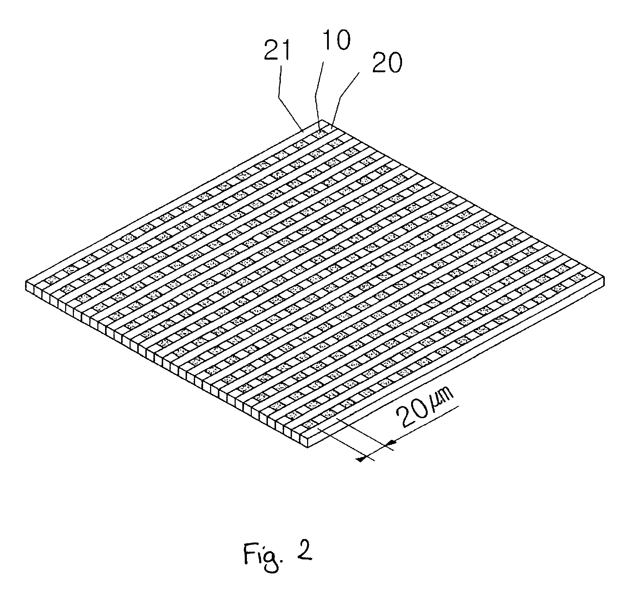

FIG. 2 shows a contact manufactured according to the present invention. The contact has a generally rectangular shape, and includes a plurality of sets of a dielectric layer 21 and a second layer provided on one side of the dielectric layer 21, wherein the dielectric layer 21 extends in a longitudinal direction thereof, and the second layer consists of a plurality of pairs of a dielectric part 20 and a conductor part 10, the pairs being continuously provided in a longitudinal direction of the second layer, wherein the sets of the dielectric layer 21 and the second layer are repeatedly stacked on one another in one direction.

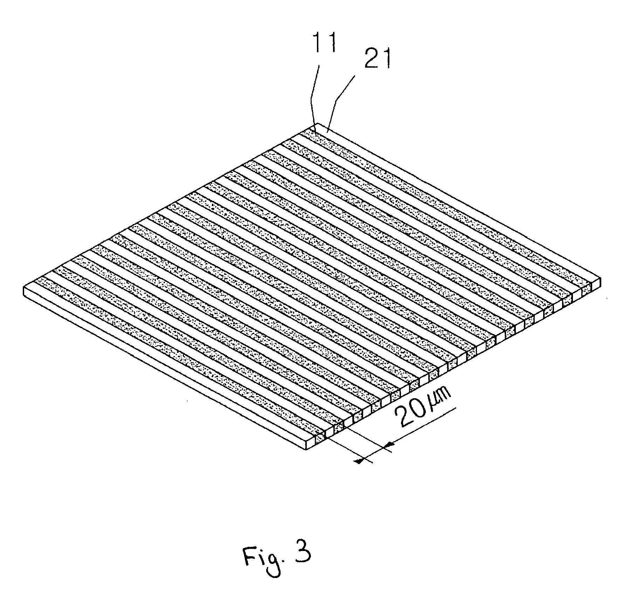

FIG. 3 shows another contact fabricated according to the present invention. The contact has a generally rectangular shape, and includes a plurality of sets of a dielectric layer 21 and a conductor layer 11 provided on one side of the dielectric layer 21, wherein the dielectric layer 21 extends in a longitudinal direction thereof, and the conductor layer 11 extends in a longitudinal direction thereof, wherein the sets of the dielectric layer 21 and the conductor layer 11 are repeatedly stacked on one another in one direction.

The contact is characterized in that a pitch between adjacent conductor parts or layers 10 or 11 has a value of 20 µm or more.

Although the pitch may have a value of below 20 µm, in order to secure structural rigidity, the pitch preferably has a minimum value of 20 µm.

Such a narrow pitch between conductor parts or layers 10 or 11 can resolve conventional problems, so that it is easily adaptable to a test for a micro semiconductor device of which a width of a lead is very narrow, and it enables free and easy arrangement of the semiconductor device on the contact with respect to a position, an interval, a quantity, displacement, etc. of the semiconductor device. This provides the effect that facilitation, convenience, utilization, and compatibility of use are all improved considerably.

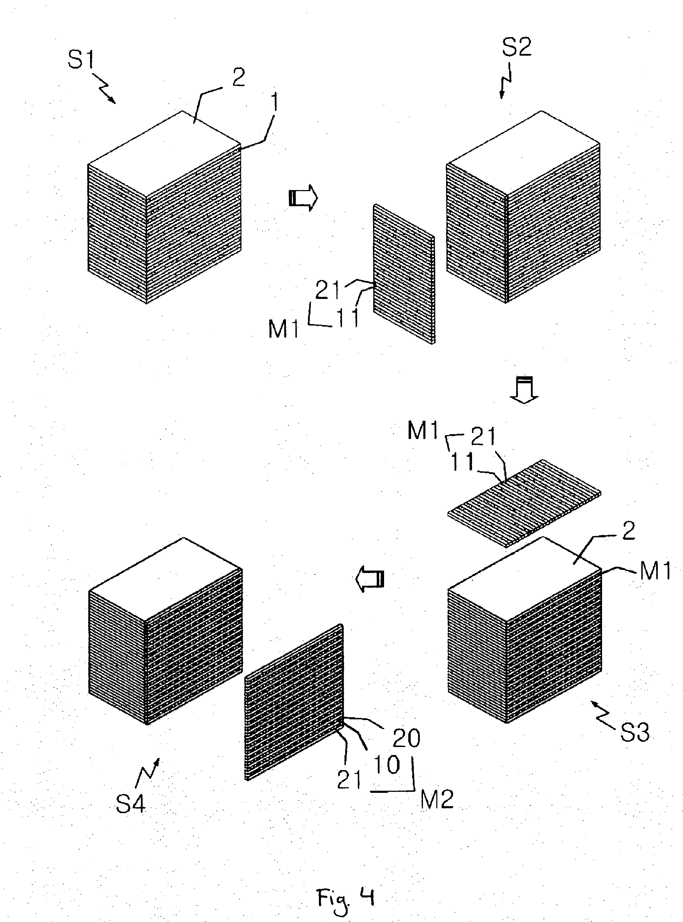

FIG. 4 shows a method of manufacturing a contact according to the present invention. The method includes a first stacking stage (S1) of continuously alternately bonding and stacking a dielectric layer 2 and a conductor layer 1 on one another to a certain height, forming a first stacked body; a first cutting stage (S2) of vertically cutting a lateral side of the first stacked body by a constant thickness across a whole height of the first stacked body, forming a first cut body M1 which consists of a plurality of sets of a dielectric layer 21 and a conductor layer 11, which extends in longitudinal directions, respectively, wherein the sets being continuously arranged on one another; a second stacking stage (S3) of continuously alternately bonding and stacking the first cut body M1, which is disposed flat, and another dielectric layer 2 in parallel on one another to a certain height, forming a second stacked body; and a second cutting stage (S4) of vertically cutting a lateral side of the second stacked body by a constant thickness across a whole height of the second stacked body, forming a second cut body M2 which consists of a plurality of sets of a dielectric layer 21 and a second layer disposed on one side of the dielectric layer 21, wherein the dielectric layer 21 extends in a longitudinal direction thereof, and the second layer consists of a plurality of pairs of a dielectric part 20 and a conductor part 10, the pairs being continuously provided in a longitudinal direction of the second layer, wherein the sets of the dielectric layer 21 and the second layer are repeatedly stacked on one another.

That is, the second cut body M2 corresponds to the contact as shown in FIG. 2, and the first cut body M1 corresponds to the contact as shown in FIG. 3.

Here, the thickness of the final contact preferably ranges from 0.5 mm to 2 mm.

Although the contact of the second cut body M2 is preferable with respect to its functionality, the contact of the first cut body M1 are also advantageous in that the first cut body M1 can be fabricated without post processes according to a type, a shape or the like of a semiconductor device that a user demands, so the manufacturing cost can be reduced, and at the same time, the first cut body can be utilized as easily as the second cut body is.

In the first cutting stage (S2), as shown with "S2" in FIG. 4, the first stacked body is vertically cut with the lateral side thereof by a constant thickness across the whole height of the first stacked body, thereby forming the first cut body M1 which consists of sets of the dielectric layer 21 and the conductor layer 11 which are continuously alternately disposed on one another, wherein the dielectric layer 21 extends in a longitudinal direction thereof.

In the second cutting stage (S4), as shown with "S4" in FIG. 4, the second stacked body that is disposed flat is vertically cut with the lateral side thereof by a constant thickness across the whole height of the second stacked body, thereby forming the second cut body M2 which consists of sets of the dielectric layer 21 and the second layer disposed on one side of the dielectric layer 21, wherein the dielectric layer 21 extends in a longitudinal direction thereof, and the second layer consists of pairs of the dielectric part 20 and the conductor part 10, the pairs being continuously provided in a longitudinal direction of the second layer, wherein the sets of the dielectric layer 21 and the second layer are repeatedly stacked on one another.

According to the contact manufactured using the above-mentioned method, since the pitch between adjacent conductor portions can be determined according to the thickness at which dielectric layer 2 and the conductor layer 1 are formed and the cut width in the manufacturing process, a very narrow pitch can be achieved as compared to the related art which requires a perforating process.

More specifically, the first stacking stage (S1) may be carried out such that a dielectric material and a conductor material are liquefied, and the liquefied materials are coated onto a base material by means of any one of coating, painting, and spraying, and then are cured.

Alternatively, a dielectric material or a conductor material in the form of a film, a sheet, or a plate may be stacked on a dielectric material or a conductor material in the form of a film, a sheet, or a plate, and then the two layers are hot-melted.

Here, the curing process may be carried out in a diversity of methods according to characteristics of a dielectric material. For example, in the case of liquefied silicone to be described later, the liquefied silicone may be cured via thermal drying.

Similar to the first stacking stage (S1), the second stacking stage (S2) may be carried out such that a dielectric material is liquefied, and the liquefied dielectric material is coated onto the first cut body M1 by means of any one of coating, application, painting, and spraying, and then is cured.

Alternatively, a dielectric material in the form of a film, a sheet, or a plate may be stacked on the first cut body M1, and then is hot-melted.

According to this method, a 20 µm thick layer can be formed without using a high-tech method, leading to an easy and precise manufacturing process with low cost. Further, since the size, interval or the like of the dielectric layer or part 20 or 21 and the conductor layer or part 10 or 11 can be freely regulated according to the thickness at which the dielectric or the conductor layer is formed, the layers can be formed in a diversity of forms while the pitch is made narrow. Further, the dielectric layer 2 and the conductor layer 1 are separately stacked, so that the two layer are not interlinked, thereby providing reliable conductivity.

Further, the first and second cutting stages (S2 and S4) may be carried out using a wafer-cutting method such as laser-cutting, wire-cutting, sawing, rotary-cutting, water-jetting, etc.

According to this method, a 20 µm thick layer can be formed without using a high-tech method, leading to an easy and precise manufacturing process with low cost, and at the same time, freely regulating the thickness of the finished contact.

As well known in the art, the dielectric material and the dielectric layer 2 may include any one selected from the group including silicone, rubber, urethane, acryl, polypropylene, and polyethylene, or any one of combinations thereof, which may be solidified from a liquefied form among nonconductive materials.

Further, as well known in the art, the conductor material and the conductor layer 1 may include any one selected from the group including Au, Ag, Cu, Al, C, and Ni, or any one of combinations thereof, which may be formed into powders among metal elements; or any one selected from the mixtures in which any one type of powders selected from the group including Au, Ag, Cu, Al, C, and Ni, or any one of combinations thereof is added to any one selected from the group including silicone, rubber, urethane, acryl, polypropylene, and polyethylene, or any one of combinations thereof.

According to a most-preferable configuration of the dielectric material and the conductor material in the present invention, the dielectric material comprises liquefied silicone, and the conductor material comprises liquefied conductive solution in which 70wt% to 90wt% of metal powders composed of C, Ag, Al, and/or Cu is added to and mixes with 10wt% to 30wt% of the liquefied silicone.

Then, because the liquefied silicone is rapidly cured via thermal drying due to its own nature, the formation of the layer is easy, secure interlayer-bonding can be obtained without a separate means, once cured, neighboring layers are distinctly formed and thus are not interlinked together, and the silicone is cured while adding the conductive metal powders therein, facilitating the formation of the conductor body.

According to a most preferably method of forming a layer in the above process, a dielectric material of liquefied silicone is coated and cured over a conductive sheet, over which liquefied conductive silicone has been cured, after which the former process is repeatedly carried out, thereby forming layers.

Then, since the conductor body is formed into a sheet type body, and thus serves as a support layer, the contact is easily manufactured, and since the dielectric silicone is coated over the conductor sheet, bonding and stacking processes are easy, ensuring rapid manufacturing of the contact.

Further, since the contact formed of silicone has elasticity due to the nature of a material, attachment and detachment of a lead terminal of a semiconductor device is easy, and continuous, repeated, prolonged use is possible due to excellent restoration force, thereby securing precision and reliability of the operation of the contact.

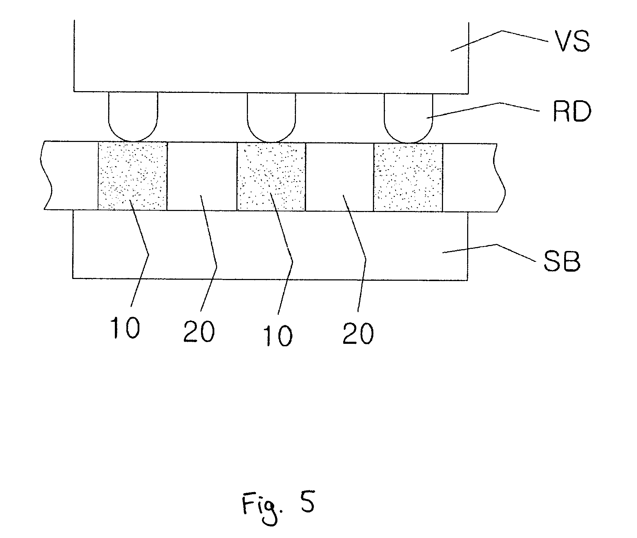

FIG. 5 shows exemplary implementation of the contact according to the present invention. As shown in FIG. 5, the contact is configured such that a lead terminal (RD) of a semiconductor device (VS) is brought into contact with the conductor part 10 on an upper portion of the contact, and a socket board (SB) for supplying electricity to the conductor part 10 is disposed at a lower portion of the contact so as to analyze input and output signals via the semiconductor device (VS) in order to test the operation of the semiconductor device.

Although detailed examples and embodiments for implementing the present invention have been described herein, detailed means or description with respect to a conventional technique is omitted or substituted with brief summary. In the drawings, the shape and size of the elements depicted thereon may be exaggeratedly drawn to provide an easily understood description of the structure of the present invention, and portions which may make the gist of the present invention unclear are partially omitted.

## Claims

1. A method of manufacturing a contact for testing a semiconductor device, the method comprising:
a first stacking stage (S1) of continuously alternately bonding and stacking a dielectric layer (2) and a conductor layer (1) on one another to a certain height, forming a first stacked body;
a first cutting stage (S2) of vertically cutting a lateral side of the first stacked body by a constant thickness across a whole height of the first stacked body, forming a first cut body (M1) which consists of a plurality of sets of a dielectric layer (21) and a conductor layer (11), which extends in longitudinal directions, respectively, wherein the sets being continuously arranged on one another;
a second stacking stage (S3) of continuously alternately bonding and stacking the first cut body (M1), which is disposed flat, and another dielectric layer (2) in parallel on one another to a certain height, forming a second stacked body; and
a second cutting stage (S4) of vertically cutting a lateral side of the second stacked body by a constant thickness across a whole height of the second stacked body, forming a second cut body (M2) which consists of a plurality of sets of a dielectric layer (21) and a second layer disposed on one side of the dielectric layer (21), wherein the dielectric layer (21) extends in a longitudinal direction thereof, and the second layer consists of a plurality of pairs of a dielectric part (20) and a conductor part (10), the pairs being continuously provided in a longitudinal direction of the second layer, wherein the sets of the dielectric layer (21) and the second layer are repeatedly stacked on one another,
**characterized in that**
the first stacking stage (S1) is carried out such that a dielectric material and a conductor material are liquefied, and the liquefied materials are coated onto a base material by means of any one of coating, painting, and spraying, and then are cured.

2. The method according to claim 1, wherein the second stacking stage (S2) is carried out such that a dielectric material is liquefied, and the liquefied dielectric material is coated onto the first cut body (M1) by means of any one of coating, application, painting, and spraying, and then is cured, or alternatively, a dielectric material in the form of a film, a sheet, or a plate is stacked on the first cut body (M1), and then is hot-melted.

3. The method according to claim 2, wherein the dielectric material and the dielectric layer comprises any one selected from the group including silicone, rubber, urethane, acryl, polypropylene, and polyethylene, or any one of combinations thereof; and
wherein the conductor material and the conductor layer comprises any one selected from the group including Au, Ag, Cu, Al, C, and Ni, or any one of combinations thereof, or alternatively any one selected from the mixtures in which any one type of powders selected from the group including Au, Ag, Cu, Al, C, and Ni, or any one of combinations thereof is added to any one selected from the group including silicone, rubber, urethane, acryl, polypropylene, and polyethylene, or any one of combinations thereof.

4. The method according to claim 1, wherein the thickness of the dielectric layer (2) and the conductor layer (1), and a width of the first and second cut bodies (M1 and M2) have a minimum value of 20 µm.

## Patentansprüche

1. Verfahren zum Herstellen eines Kontakts zum Testen einer Halbleitervorrichtung, wobei das Verfahren umfasst:
eine erste Schichtungs-Phase (S1), in der kontinuierlich eine dielektrische Schicht (2) und eine Leiterschicht (1) abwechselnd gebondet und bis zu einer bestimmten Höhe aufeinander geschichtet werden und ein erster Schicht-Körper ausgebildet wird;
eine erste Schneid-Phase (S2), in der eine Längsseite des ersten Schicht-Körpers in einer konstanten Dicke über eine gesamte Höhe des ersten Schicht-Körpers vertikal geschnitten wird und ein erster Schnitt-Körper (M1) ausgebildet wird, der aus einer Vielzahl von Gruppen aus einer dielektrischen Schicht (21) und einer Leiterschicht (11) besteht, die sich jeweils in Längsrichtungen erstrecken, wobei die Gruppen kontinuierlich aufeinander angeordnet sind;
eine zweite Schichtungs-Phase (S3), in der kontinuierlich der erste Schnitt-Körper (M1), der flach angeordnet ist, und eine weitere dielektrische Schicht (2) abwechselnd gebondet und bis zu einer bestimmten Höhe parallel aufeinander geschichtet werden und ein zweiter Schicht-Körper ausgebildet wird; und
eine zweite Schneid-Phase (S4), in der eine Längsseite des zweiten Schicht-Körpers in einer konstanten Dicke über eine gesamte Höhe des zweiten Schicht-Körpers vertikal geschnitten wird und ein zweiter Schnitt-Körper (M2) ausgebildet wird, der aus einer Vielzahl von Gruppen aus einer dielektrischen Schicht (21) und einer zweiten Schicht besteht, die an einer Seite der dielektrischen Schicht (21) angeordnet ist, wobei sich die dielektrische Schicht (21) in einer Längsrichtung derselben erstreckt und die zweite Schicht aus einer Vielzahl von Paaren aus einem dielektrischen Teil (20) und einem Leiterteil (10) besteht und die Paare kontinuierlich in einer Längsrichtung der zweiten Schicht angeordnet sind, wobei die Gruppen aus der dielektrischen Schicht (21) und der zweiten Schicht wiederholt übereinander geschichtet werden,
**dadurch gekennzeichnet, dass** die erste Schichtungs-Phase (S1) so ausgeführt wird, dass ein dielektrisches Material und ein Leitermaterial verflüssigt werden und ein Trägermaterial mittels Auftragen, Streichen und Spritzen mit den verflüssigten Materialien beschichtet und diese anschließend ausgehärtet werden.

2. Verfahren nach Anspruch 1, wobei die zweite Schichtungs-Phase (S2) so ausgeführt wird, dass ein dielektrisches Material verflüssigt wird und der erste Schnitt-Körper mittels Auftragen, Aufbringen, Streichen und Spritzen mit den verflüssigten Material beschichtet wird und dieses anschließend ausgehärtet wird oder als Alternative dazu ein dielektrisches Material in Form eines Films, einer Lage oder einer Platte auf den Schnitt-Körper (M1) geschichtet und dann heißgeschmolzen wird.

3. Verfahren nach Anspruch 2, wobei das dielektrische Material und die dielektrische Schicht ein Material umfassen, das aus der Gruppe ausgewählt wird, die Silikon, Kauschuck, Urethan, Acryl, Polypropylen und Polyethylen oder beliebige Kombinationen derselben einschließt; und
das Leitermaterial und die Leiterschicht ein beliebiges Material, das aus der Gruppe ausgewählt wird, die Au, Ag, Cu, Al, C und Ni oder beliebige Kombinationen derselben einschließt, oder als Alternative dazu ein Material umfassen, das aus den Gemischen ausgewählt wird, bei denen ein Typ Pulver, die aus der Gruppe ausgewählt werden, die Au, Ag, Cu, Al, C und Ni oder beliebige Kombinationen derselben einschließt, einem Material zugesetzt wird, das aus der Gruppe ausgewählt wird, die Silikon, Kauschuck, Urethan, Acryl, Polypropylen und Polyethylen oder beliebige Kombinationen derselben einschließt.

4. Verfahren nach Anspruch 1, wobei die Dicke der dielektrischen Schicht (2) und der Leiterschicht (1) sowie eine Breite des ersten und des zweiten Schnitt-Körpers (M1 und M2) einen minimalen Wert von 20 µm haben.

## Revendications

1. Une méthode de fabrication d'un contact pour essai d'un dispositif à semi-conducteur, cette méthode comprenant :
une première phase d'empilement (S1) par alternance continue de liaison et d'empilement d'une couche diélectrique (2) et d'une couche conductrice (1) l'une sur l'autre jusqu'à une certaine hauteur pour former un premier empilement ;
une première phase de découpe (S2) découpant verticalement un côté latéral du premier empilement sur une épaisseur constante et sur toute la hauteur du premier empilement, pour former un premier corps de coupe (M1) constitué de plusieurs ensembles de couches diélectriques (21) et de couches conductrices (11), s'étendant respectivement dans des directions longitudinales, ces ensembles étant disposés en continu l'un sur l'autre ;
une deuxième phase d'empilement (S3) alternant en continu la liaison et l'empilement du premier corps de coupe (M1), disposée à plat, et d'une autre couche diélectrique (2) parallèles entre elles, jusqu'à une certaine hauteur, pour former un deuxième empilement ; et
une deuxième phase de découpe (S4) découpant verticalement un côté latéral du deuxième empilement sur une épaisseur constante et sur toute la hauteur du deuxième empilement, pour former un deuxième corps de coupe (M2) constituée de plusieurs ensembles de couche diélectrique (21) et d'une deuxième couche disposée sur un côté de la couche diélectrique (21), dans lequel la couche diélectrique (21) s'étend dans une direction longitudinale, et dans lequel la deuxième couche est constituée de plusieurs paires de parties diélectriques (20) et de parties conductrices (10), ces paires étant disposées en continu dans un sens longitudinal de la deuxième couche, et dans lequel les ensembles de couche diélectrique (21) et de deuxième couche sont empilés de façon répétitive l'une sur l'autre,
**caractérisé en ce que** la première phase d'empilement (S1) est effectuée de façon qu'un matériau diélectrique et un matériau conducteur sont liquéfiés et que ces matériaux liquéfiés sont enduits sur un matériau de base par une des méthodes d'enduction, de peinture et de pulvérisation, puis durcis.

2. La méthode selon la revendication 1, où la deuxième phase d'empilement (S2) est effectuée de façon qu'un matériau diélectrique est liquéfié et que le matériau diélectrique est enduit sur le premier corps de coupe (M1) par une des méthodes d'enduction, d'application, de peinture et de pulvérisation, puis durci, ou selon une autre méthode, qu'un matériau diélectrique sous forme de film, de feuille ou de plaque est empilé sur le premier corps de coupe (M1) puis fondu à la chaleur.

3. La méthode de la revendication 2, où le matériau diélectrique et la couche diélectrique comprennent un matériau sélectionné dans le groupe comprenant silicone, caoutchouc, uréthane, acryl, polypropylène et polyéthylène, ou une combinaison quelconque de ceux-ci ; et
où le matériau conducteur et la couche conductrice comprennent un élément sélectionné parmi le groupe comprenant Au, Ag, Cu, Al, C et Ni, ou une combinaison quelconque de ceux-ci, ou selon une autre méthode un mélange sélectionné dans un type quelconque de poudre sélectionné dans le groupe comprenant Au, Ag, Cu, Al, C et Ni, ou une combinaison quelconque de ceux-ci est ajoutée à un élément sélectionné dans le groupe comprenant silicone, caoutchouc, uréthane, acryl, polypropylène et polyéthylène, ou toute combinaison de ceux-ci.

4. La méthode selon la revendication 1, dans laquelle l'épaisseur de la couche diélectrique (2) et de la couche conductrice (1), et dans laquelle une largeur des premier et deuxième corps de coupe (M1 et M2) ont une valeur minimale de 20 µm.
